# EUROPEAN PATENT SPECIFICATION

(11) **EP 2 904 411 B1**
(45) Date of publication and mention of the grant of the patent: **15.05.2019**
(21) Application number: 13779512.6
(22) Date of filing: 08.10.2013
(51) Int. Cl.: G01R 29/18, G01R 31/02, H02H 3/34, H02H 7/09

(54) **PHASE SEQUENCE DETECTION**
PHASENSEQUENZNACHWEIS
DÉTECTION DE SÉQUENCE DE PHASE

(30) Priority: 08.10.2012 DK 201270615
(43) Date of publication of application: 12.08.2015
(73) Proprietor: Lodam Electronics A/S, 6400 Sønderborg (DK)
(72) Inventor: ECKHOLDT, Christian, DK-6300 Gråsten (DK)
(74) Representative: Patentgruppen A/S
(86) International application number: PCT/DK2013/050317
(87) International publication number: WO 2014/056505

(56) References cited:
- EP-A2- 1 180 840
- DE-A1- 3 211 815
- JP-A- 2009 244 217
- US-A- 5 828 309
- ANONYMOUS: "PRIMARY POWER PHASE MONITOR", IBM TECHNICAL DISCLOSURE BULLETIN, INTERNATIONAL BUSINESS MACHINES CORP. (THORNWOOD), US, vol. 19, no. 11, 1 April 1977 (1977-04-01) , XP002047924, ISSN: 0018-8689

## Description

### Field of the invention

The present invention relates to phase sequence detectors for use with frequency controlled compressors, and methods for detecting phase sequence of variable frequency supply signals.

### Background of the invention

Electrical compressors and other electrical motors driven by 3-phase AC supply are often sensitive to the sequence of the three phases. Some configurations may not work or even be damaged if connected incorrectly to the supply, and in some configurations the compressor or motor may run but in reverse, which is prone to cause problems with the rest of the system that the compressor or other motor is part of.

Different kinds of phase sequence detectors have been developed to inform the user or shut down the supply if an incorrect phase sequence is detected. Some of these work by means of optocouplers establishing pulses indicative of phase differences between the three supply phases. However, for frequency controlled compressors typically driven by inverters acting as switched supplies, thereby producing pulsed 3-phase supply signals for the compressor, e.g. pulse width modulated supply signals, the prior art phase sequence detectors do not work as the narrow pulses are not sufficient to convey a signal by means of inherently slow optocouplers and/or the output of the optocouplers will be pulsating at the switching frequency of the inverter, thereby not establishing pulses indicative of the phase differences of the supply signals.

Further, the logic of the prior art phase sequence detectors acting on the phase difference indicative pulses of the optocouplers are typically relying on a certain frequency of the three phases, typically 50 Hz og 60 Hz, e.g. by comparing phase differences with absolute thresholds. Such phase sequence detectors are therefore not usable with frequency controlled compressors, where the supply phases may vary between e.g. 20 Hz and 200 Hz. Phase sequence detectors which measure the frequency of the supply phases in order to adapt to variable supply frequencies require relatively much additional logic and processing power.

Document JP 2009 244217 A discloses a control device of a compressor and a control device of an electric motor which supply three-phase AC power.

Document EP 1 180 840 A2 discloses a power supply negative-phase detecting circuit for electronic equipment using a three-phase AC power supply source including a pulse generator for generating a pulse indicative of the phase difference between any pair of two phases of the three-phase AC power.

Document DE 32 11 815 A1 discloses a three-phase control circuit which is so simple, and thus also inexpensive, that it can be installed in mass production as service aid in three-phase devices.

Document "Primary Power Phase monitor", IBM Technical Disclosure Bulletin, International Business Machines Corp., vol. 19, no. 11, 1 April 1977, discloses a primary power phase monitor circuit used to detect power phase reversal and to transmit that information to a power controller. The input to the circuit is a three-phase power line, and the outputs are completely isolated from the input power line.

Document US 5 828 309 A discloses a power source miswiring detection apparatus for detecting a miswiring of wires of a power source, including a pulse generator for generating a first pulse having a pulse width corresponding to a first phase difference between a first pair of two phases of a three-phase alternating power source.

### Summary of the invention

The inventors have realised the above-mentioned problems of the prior art, and objects of their invention comprise providing a new phase sequence detection method and a new phase sequence detector. The solution of the above-mentioned problems is achieved by the method, as defined in claim 1, and the detector, as defined in claim 8; additional features are defined in the corresponding dependent claims. The present invention relates to a phase sequence detection method for determining phase sequence in a 3-phase motor driver signal, the phase sequence detection method comprising the steps of
receiving a first pulse train P_{L1L2}, pulses of the first pulse train being indicative of a phase difference between a first phase L1 and a second phase L2;
receiving a second pulse train P_{L2L3}, pulses of the second pulse train being indicative of a phase difference between a second phase L2 and a third phase L3;
determining a pulse shift ratio representing a ratio of pulse shift DT1 to pulse period DT2 of said first and second pulse trains; and
determining said phase sequence of said 3-phase motor driver signal on the basis of said pulse shift ratio.

The present invention provides an advantageous method for determining the phase sequence of three phases by relative measurements, meaning that it works without knowing the driver frequency, measuring the driver frequency or performing absolute time measurements. In other words, the present invention enables phase sequence detection for motor driver signals with variable frequency commonly used with frequency controlled motors, compressors, etc., and it does so in an efficient and fast way, which means that it does not require much processing power and is anyway able to provide a fast result, which may be critical for motor protection and security purposes.

The invention is thereby novel and inventive over the prior art solutions, as they only work for the specific driver frequency that they are designed for, or by measuring the actual driver frequency before being able to determine phase faults.

The first and second pulse trains are preferably provided by an advantageous pulse generator according to the present invention, as described below, or is provided from any other pulse generator arranged to provide two pulse trains, each comprising pulse events representing the phase difference between two of the three phases.

By pulse shift is meant the timing difference between pulse events in the two pulse trains, e.g. a value representing the time from a pulse event, e.g. a falling edge, in one of the pulse trains to a corresponding pulse event in the other pulse train.

By pulse period is meant the timing difference between pulse events in the same pulse train, e.g. a value representing the time from a pulse event, e.g. a falling edge, in one of the pulse trains to a corresponding pulse event in the same pulse train.

According to the present invention the pulse shift and pulse period may be measured as times, e.g. in milliseconds, but are preferably simply represented as relative time-representations with comparable units such as clock ticks, samples, timer events, counter values, ramp signal levels, etc. Several of the advantages such as the quickness and low processing requirements of the present invention are related to the feature that the invention facilitates determining the phase sequence without measuring absolute frequencies of the phases, or absolute times at all. The method simply needs comparable representations of the pulse shift and pulse period in any available unit of measure.

It is noted that the determining a pulse shift and pulse period may according to a preferred embodiment of the present invention be carried out by determining two values that are assumedly the pulse shift and pulse period values (DT1, DT2) but which may turn out by not fitting to the compared ratios to be in fact e.g. a pulse period and double pulse period of the same pulse signal or other invalid values.

In a preferred embodiment of the present invention the pulse shift and pulse period are determined simultaneously, but may in an alternative embodiment be determined sequentially, or their ratio be determined directly.

In a preferred embodiment of the present invention the method is carried out several times, preferably two or three times, and the conclusion that the phase sequence is correct only established if all, e.g. two or three, results have this outcome, or less preferred but within the scope of the invention, a major number of the tests have this outcome.

An advantageous embodiment of the present invention is obtained when said steps of determining said pulse shift ratio and determining said phase sequence are obtained by the steps of:
determining a first timing difference DT1 representing a relative time between a first pulse event FE1 of one of said first or second pulse trains and a second pulse event FE2 of one of said first or second pulse trains;
determining a second timing difference DT2 representing a relative time between said first pulse event FE1 and a third pulse event FE3 of one of said first or second pulse trains;
determining said phase sequence of said 3-phase motor driver signal as being first - second - third phase when said first timing difference DT1 amounts to one third of said second timing difference DT2 subject to a predetermined tolerance when said first pulse event FE1 occurred in said first pulse train P_{L1L2}, or when said first timing difference DT1 amounts to two thirds of said second timing difference DT2 subject to a predetermined tolerance when said first pulse event FE1 occurred in said second pulse train P_{L2L3}.

According to a preferred embodiment of the present invention the determination of pulse shift and pulse period are carried out at the same time by registering three successive pulse events, among which the first FE1 and third FE3 are assumedly two consecutive pulse events in the same pulse train, and the second pulse event FE2 is assumedly an intermediate pulse event in the other pulse train. In a preferred embodiment of the invention, the pulse shift is determined as the time value difference between the first and second pulse events, and the pulse period is determined as the time value difference between the first and third pulse events. Note that because the present invention only needs relative time measurements, a time value in this context simply means a value changing with time, and can be any counter type with arbitrary scaling relative to actual time.

The present embodiment of the invention is advantageous again by not requiring any real time measurements, but simply requiring some indication of the ratio between the shift and the period - and in fact only requiring this of the assumed shift and assumed period, as the step of using the ratio to determine the phase sequence is able to disregard ratios not representing a shift to period ratio, but rather e.g. a period to double period ratio as mentioned above, which may e.g. occur when a phase is disconnected.

An advantageous embodiment of the present invention is obtained when said method further comprises at least one of the following steps:
determining a phase loss of said first phase L1 or said third phase L3 when said first timing difference DT1 amounts to one half of said second timing difference DT2 subject to a predetermined tolerance;
determining a phase loss of said second phase L2 when said first timing reference DT1 amounts to zero or equals said second timing difference DT2 subject to predetermined tolerances.

According to this preferred embodiment of the present invention, the inventive method is not only able to determine the phase sequence, but is also able to determine phase loss, and even suggest which phase has been lost, simply by analysing the two pulse trains.

An advantageous embodiment of the present invention is obtained when the method comprises a step of having a pulse generator PG establish said first pulse train P_{L1L2} and said second pulse train P_{L2L3} on the basis of the first phase L1, second phase L2 and third phase L3 of said 3-phase motor driver signal; and wherein the method further comprises at least one of the following steps:
determining that the pulse generator PG is not connected to said first phase L1 when no pulse events are detected in said first pulse train P_{L1L2} within a predetermined timeout time, e.g. 60 ms, or among first, second and third pulse events FE1, FE2, FE3 of said pulse trains P_{L1L2}, P_{L2L3};
determining that the pulse generator PG is not connected to said third phase L3 when no pulse events are detected in said second pulse train P_{L2L3} within a predetermined timeout time, e.g. 60 ms, or among said first, second and third pulse events FE1, FE2, FE3.

According to a preferred embodiment, faults in the connection of the phase sequence detector to the compressor driver signal may be determined when no pulse events are detected in the associated pulse trains, i.e. disconnection of phase L1 if no events occurs in the first pulse train, and disconnection of L3 if no events occurs in the second pulse train. The non-occurrence of pulse events may e.g. be established after a certain time has gone, e.g. a time corresponding to the longest possible pulse period according to the actual application, e.g. 50 ms, plus a reasonable tolerance, e.g. 10 ms, or it may be established when all three of the three detected pulse events have occurred in the same pulse train. Again it is noted that all times, including timeouts, may according to the present invention preferably be determined by relative means such as clock ticks, number of samples, counter values, etc.

An advantageous embodiment of the present invention is obtained when said 3-phase motor driver signal is a variable frequency driver signal.

A great feature is that the phase sequence detector of the present invention works reliably, efficiently and quickly with variable frequency driver signal commonly used with frequency controlled motors, compressors, etc., even with no prior or additional information about the frequencies, or any absolute measurements thereof. A particularly advantageous embodiment of the present invention is therefore obtained when said 3-phase motor driver signal is a pulse width modulated PWM driver signal or other pulsed signal for convenient controlling of frequency.

An advantageous embodiment of the present invention is obtained when the pulse generator PG comprises first and second pulse conversion parts C1, R5, C2, R6 arranged to convert pulsed signals, e.g. PWM signals, at said 3-phase motor driver signal to substantially continuous signals.

In order to overcome problems with e.g. optocouplers reacting slower than narrow pulses of pulse modulated driver signals or difficulties in comparing implicit phases of pulse-modulated sine curves, the pulse generator preferably comprises pulse conversion means according to the present invention.

An advantageous embodiment of the present invention is obtained when the method comprises a step of starting a counter upon detection of said first pulse event FE1, and wherein said pulse shift DT1 is determined as a value of the counter upon detection of said second pulse event FE2 and said pulse period DT2 is determined as a value of the counter upon detection of said third pulse event FE3.

Due to the timing advantageously being relative in the present invention, the determination of the pulse shift and pulse period can simply be made by reading a counter value. The counter need not represent any correspondence with real time, signal samples, frequencies, etc., as the present invention uses only ratios of counter values for detecting phase sequence.

Further is described a pulse generator PG for use in a phase sequence detector, comprising
first, second and third phase inputs L1, L2, L3;
first and second pulse outputs P_{L1L2}, P_{L2L3};
first and second pulse conversion parts C1, R5, C2, R6 arranged to convert pulsed signals, e.g. PWM signals, at said first, second and third phase inputs L1, L2, L3 to substantially continuous signals;
a first comparator U1 arranged between said first and second phase inputs arranged to establish a pulse train at said first pulse output P_{L1L2}, pulses of the pulse train being indicative of a phase difference between said first phase input L1 and said second phase input L2; and
a second comparator U2 arranged between said second and third phase inputs arranged to establish a pulse train at said second pulse output P_{L2L3}, pulses of the pulse train being indicative of a phase difference between said second phase input L2 and said third phase input L3.

Hereby is obtained an advantageous pulse generator facilitating phase sequence detection of 3-phase signals, which is particularly advantageous for pulsed phases, e.g. pulse-modulated driver signals for motors, compressors, etc.

By substantially continuous signals are referred to signals e.g. resembling sine curves, but possibly comprising spurs, steps or other artefacts associated with the eliminated pulses, as long as the artefacts do not involve rapid rising from or returning to the baseline for a major part of pulses occurring in the phase signals L1, L2 and L3.

A comparator according to above-described pulse generator PG is preferably an optocoupler or an opto-isolating circuit using light waves representing current flow or differing potential in one electrical circuit to modulate current flow in another electrical circuit, preferably by a light emitting diode responsive to differing potential in the first electrical circuit and a photosensitive semiconductor switching current flow in the second electrical circuit in response thereto. Other types of comparators suitable for use in the pulse generator PG may e.g. comprise other type of galvanic isolating devices such as digital isolators using e.g. inductive or capacitive mechanisms for modulating an output signal based on an input signal, or non-isolating components usable for establishing pulses based on voltage or current levels of an input signal. The pulse train may be established by e.g. pulling an output of the comparator, e.g. optocoupler, up when no positive potential difference is detected in the first electrical circuit, and making the optocoupler pull the output down upon detection of a positive difference in potential.

An advantageous embodiment is obtained when said first pulse conversion part C1, R5 is arranged as a fifth resistor R5 and a first capacitor C1 connected in series between a cathode of a first diode (D1) in series with said first phase input L1 and said second phase input L2 and in parallel to a series-connection of a first resistor R1 and said first comparator U1; and wherein said second pulse conversion part C2, R6 is arranged as a sixth resistor R6 and a second capacitor C2 connected in series between an anode of a second diode D2 in series with said third phase input L3 and said second phase input L2 and in parallel to a series-connection of a second resistor R2 and said second comparator U2.

An advantageous embodiment is obtained when said first and second comparators U1, U2 comprise optocouplers. Thereby galvanic isolation and protection of the typically low-voltage analysis circuit is obtained.

The present invention further relates to a phase sequence detector for use with a frequency controlled compressor M, comprising
first, second and third phase inputs L1, L2, L3 for receiving a 3-phase compressor driver signal;
a pulse generator PG connected to said first, second and third phase inputs; and
a pulse analyser PA connected to first and second pulse outputs P_{L1L2}, P_{L2L3} of said pulse generator;
wherein said pulse generator PG is arranged to establish a first pulse train at said first pulse output P_{L1L2}, pulses of the first pulse train being indicative of a phase difference between said first phase input L1 and said second phase input L2; and a second pulse train at said second pulse output P_{L2L3}, pulses of the second pulse train being indicative of a phase difference between said second phase input L2 and said third phase input L3; and
wherein said signal analyser PA is arranged to establish a pulse shift ratio representing a ratio of pulse shift DT1 to pulse period DT2 of said first and second pulse outputs, and to determine a phase sequence of signals received at said first, second and third phase input L1, L2, L3 on the basis of said pulse shift ratio.

By the present invention is obtained an advantageous phase sequence detector which is able to determine phase sequence even for variable frequency, pulse-modulated driver signals in an efficient and quick way requiring no prior or additional knowledge of the specific frequencies, or any absolute measurement thereof.

An advantageous embodiment of the present invention is obtained when said signal analyser PA comprises a counter, and wherein said signal analyser is arranged to start said counter upon detection of a first pulse event FE1, e.g. a falling edge, of one of said first or second pulse trains, and to determine said pulse shift DT1 as a value of the counter upon detection of a second pulse event FE2 of one of said first or second pulse trains, and to determine said pulse period DT2 as a value of the counter upon detection of a third pulse event FE3 of one of said first or second pulse trains.

Due to the timing advantageously being relative in the present invention, the determination of the pulse shift and pulse period can simply be made by reading a counter value. The counter need not represent any correspondence with real time, signal samples, frequencies, etc., as the present invention uses only ratios of counter values for detecting phase sequence.

An advantageous embodiment of the present invention is obtained when said pulse generator PG comprises first and second pulse conversion parts C1, R5, C2, R6 arranged to convert pulsed signals, e.g. PWM signals, at said 3-phase compressor driver signal to substantially continuous signals.

In order to overcome problems with e.g. optocouplers reacting slower than narrow pulses of pulse modulated driver signals or difficulties in comparing implicit phases of pulse-modulated sine curves, the pulse generator preferably comprises pulse conversion means according to the present invention.

Further is described a phase shift indicative pulse generating method for use with 3-phase pulse modulated driver signals comprising the steps of
receiving a first, second and third phase L1, L2, L3;
converting any pulse-modulated phases L1, L2, L3 to substantially continuous signals;
establishing a first pulse train P_{L1L2} with pulses being indicative of a phase difference between said first phase L1 and said second phase L2; and
establishing a second pulse train P_{L2L3} with pulses being indicative of a phase difference between said second phase L2 and said third phase L3.

Hereby is obtained an advantageous method for establishing pulse trains indicative of phase differences of 3 phases which are pulse modulated and possibly with variable frequency, as commonly used for frequency control of motors, compressors, etc.

### The drawings

The invention will in the following be described with reference to the drawings where
fig. 1 is an overall block diagram of an embodiment of the invention,
fig. 2 illustrates an embodiment of a pulse generator for non-pulsed supply signals,
fig. 3 illustrates signals occurring in an embodiment as in fig. 2,
fig. 4 illustrates a pulse width modulated supply signal,
fig. 5 illustrates an embodiment of a pulse generator for pulsed supply signals,
fig. 6 illustrates a 3-phase PWM supply signal with correct phase sequence,
fig. 7 illustrates pulses generated by a pulse generator on the basis of the PWM supply signal of fig. 6,
fig. 8 is a flow chart illustrating a basic embodiment of phase sequence detection according to the present invention,
fig. 9 illustrates a correct way to connect compressor and phase sequence detector,
figs. 10 - 13 illustrate various faulty ways to connect compressor and phase sequence detector,
fig. 14 illustrates a 3-phase PWM supply signal with wrong phase sequence,
figs. 15 - 18 illustrate pulses generated by a pulse generator under the faulty connection conditions of fig. 10 - 13, and
fig. 19 is a flow chart illustrating a more advanced embodiment of phase sequence detection according to the present invention.

### Detailed description

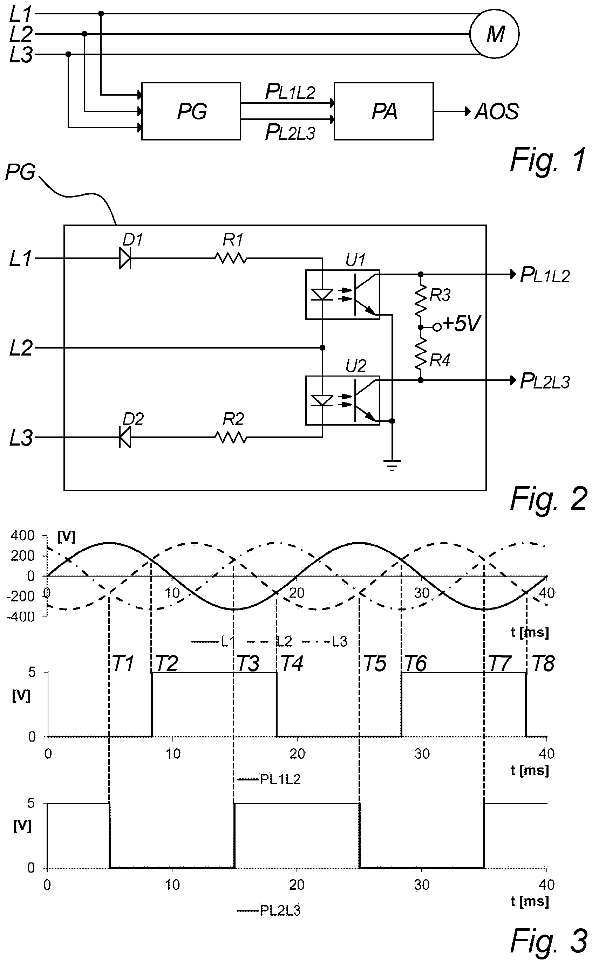

Fig. 1 illustrates a block diagram of an embodiment of the present invention. Fig. 1 comprises an electrical compressor M or other electrical motor driven by a 3-phase AC supply comprising three phases L1, L2, L3 with internal phase differences of 120 degrees. For the purpose of the present description and examples it is assumed that the compressor M is configured for phase L2 being 120 degrees delayed compared to phase L1, and phase L3 being 240 degrees delayed compared to phase L1, making the correct phase sequence L1 - L2 - L3. However, any phase sequence standard and phase naming convention is within the scope of the present invention, so when the present description mentions correct, wrong or opposite phase sequence, L1, L2 and L3, etc., the skilled person will be able to apply this to a particular scenario, naming scheme and requirements.

Fig. 1 further comprises a phase sequence detector comprising a pulse generator PG and a pulse analyser PA. The pulse generator PG has three phase inputs L1, L2, L3 to receive the same three phases as the compressor M, and it has two pulse outputs P_{L1L2} and P_{L2L3} which are connected to inputs of the pulse analyser. The pulse signal P_{L1L2} comprises pulses indicative of phase differences between phases L1 and L2, and the pulse signal P_{L2L3} comprises pulses indicative of phase differences between phases L2 and L3.

The pulse analyser PA analyses the two pulse signals and determines on that basis a phase sequence of the three phase inputs L1, L2, L3. It may e.g. output an alarm, informational signal, relay control signal, etc., e.g. by means of an analyser output signal AOS, or it may comprise a display, light emitting diodes, or other means for directly indicating the analysis result. In a preferred embodiment the pulse analyser may further be able to determine information about phaseloss or other irregularities of the three supply phases simply on the basis of the two pulse signals P_{L1L2} and P_{L2L3} .

Fig. 2 illustrates an embodiment of a pulse generator PG for non-pulsed supply phases. It comprises a first phase input L1 which is connected to the diode connection of a first optocoupler U1 via a first diode D1 and a first resistor R1. The other diode connection of the first optocoupler U1 is connected to a second phase input L2. The collector connection of the first optocoupler U1 is connected to a DC supply through a third resistor R3, and the emitter connection of U1 is grounded. The collector connection of the first optocoupler U1 is also the pulse output P_{L1L2}.

The pulse generator of fig. 2 further comprises a second optocoupler U2 where a diode connection is also connected to the second phase input L2, and the other diode connection is connected through a second resistor R2 and a second diode D2 to the third phase input L3. The collector and emitter connections of the second optocoupler U2 are coupled similar to the first optocoupler U1, except that the collector of U2 is the second pulse output P_{L2L3}.

When the instant voltage at first phase input L1 is higher than the instant voltage at second phase input L2, a current flows through the first diode D1 and the first optocoupler U1, causing the optocoupler U1 to ground the pulse output P_{L1L2}, which is otherwise pulled up to +5V by the DC supply and R3. In other words, P_{L1L2} goes high each time the instant voltage of L1 is below the instant voltage of L2, and thereby P_{L1L2} gets to contain pulses indicative of relationship between the phases of L1 and L2.

In a similar way P_{L2L3} goes high each time the instant voltage of L2 is below the instant voltage of L3, and thereby P_{L2L3} gets to contain pulses indicative of relationship between the phases of L2 and L3.

This is further illustrated in fig. 3, where the upper plot illustrates the 3 phases L1, L2 and L3 on a horizontal time axis with the instant voltage levels indicated along the vertical axis. As can be seen from the plot, the three phases all have a period time of 20 ms, corresponding to a frequency of 50 Hz, and the phase sequence is L1 - L2 - L3.

Below the phases plot in fig. 3 is a plot of the pulse signal P_{L1L2} established by a pulse generator PG according to fig. 2. The horizontal axis indicates time on the same scale as the upper plot, and the vertical axis refers to voltage levels 0 and +5V. By means of the dashed, vertical guiding lines T2, T4, T6 and T8, it can be seen that the pulse signal P_{L1L2} is high, i.e. +5V, when the level of L2 is greater than the level of L1.

In a similar way, the lower plot in fig. 3 illustrates the pulse signal P_{L2L3} of the pulse generator PG of fig. 2, and it can be seen, guided by dashed lines T1, T3, T5 and T7, that the pulse signal P_{L2L3} is high when the level of L3 is greater than the level of L2.

It is noted, that a pulse generator within the scope of the present invention may use a different type of comparator component or circuit instead of the optocoupler. The comparator should be suitable for comparing two phases to detect when one phase has higher voltage than the other. Suitable alternatives may e.g. comprise digital isolators e.g. using inductive or capacitive mechanisms for transferring behaviour from the isolated input to the output, or non-isolated comparator circuits or components, e.g. based on transistors.

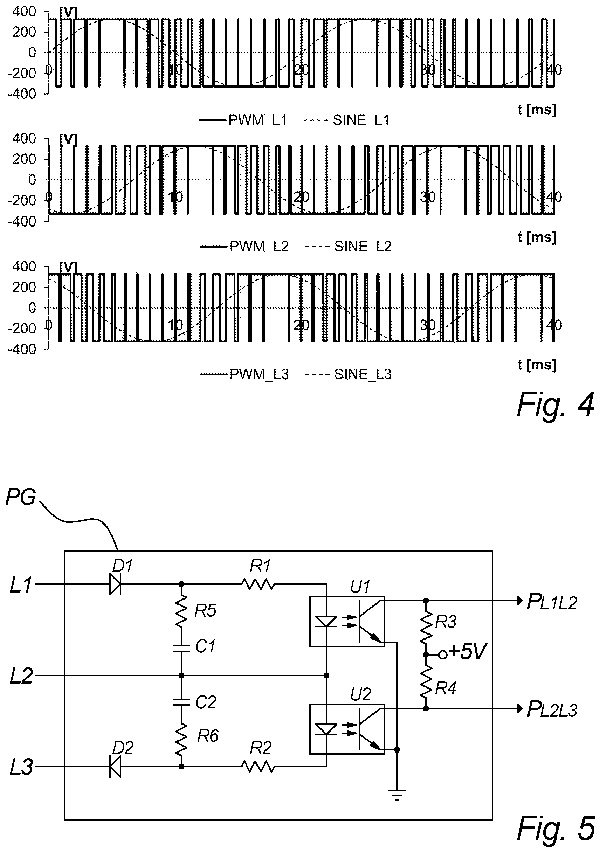

Fig. 4 comprises plots of an example of input phases that are pulsed, in this example pulse width modulated signals corresponding to the sine wave signals illustrated in the plot of fig. 3. Using pulsed power signals for driving e.g. compressors is a common and advantageous way of controlling motor speed. The upper plot in fig. 4 shows the 50 Hz sine wave phase L1 on the same time scale as in fig. 3, and together with that, a pulse width modulated version denoted PWM L1. As can be seen, the PWM version comprises several pulses, and thereby several zero-transitions, for each zero-transition of the sine wave version. The number, and, inversely correspondingly, the width of pulses in the PWM power signal is a parameter of the pulse width modulation. In the examples are selected a very coarse pulse width modulation, i.e. with low switching frequency, in order to establish visually comprehensible PWM pulses, i.e. only few pulses per period, but in real systems there will typically be used a much higher switching frequency and thereby be generated a much higher number of pulses per period, as the switching frequency is related to the resolution of which the smooth sine wave is represented by the PWM signal. It is noted, that any density of PWM pulses and other pulse modulation techniques suitable for power transmission and driving motor-type consumers, e.g. compressors, are within the scope of the present invention.

The two other plots of fig. 4 illustrate sine- and PWM-versions of phases L2 and L3 in a similar way as described above for L1. It can be seen, that the PWM power signals for the three phases are equal but shifted 120 degrees as with the sine waves.

One of the problems of the prior art phase sequence detectors can be appreciated by attempting to use the PWM power signals illustrated in fig. 4 for input phases L1, L2 and L3 of a pulse generator as seen in fig. 2. The output pulse signals P_{L1L2} and P_{L2L3}, which are expected to contain one pulse for each sine period, will now contain a period for each PWM pulse, i.e. relating to the PWM switching frequency instead of the AC power signal frequency, or, if the switching frequency is too high for the optocouplers to be able to switch accordingly, the pulse signals P_{L1L2} and P_{L2L3}, will simply not contain any pulses, or only contain pulses when there is sufficient time between successive flanks of e.g. L1 and L2 to leave the optocoupler time to switch.

Fig. 5 illustrates an embodiment of a pulse generator. It comprises a pulse generator PG which can be used in a phase sequence detector according to an embodiment of the present invention as illustrated in fig. 1 for pulsed phases L1, L2 and L3, e.g. from a PWM motor driver.

Compared to the pulse generator of fig. 2, the embodiment of fig. 5 comprises first and second pulse conversion parts comprising a fifth resistor R5 and a first capacitor C1 coupled in series between phase inputs L1 and L2, and a sixth resistor R6 and second capacitor C2 coupled in series between phase inputs L2 and L3.

The first capacitor is at least partially charged each time the level of L1 is higher than the level of L2, which for pulsed phases means each time L1 is high while L2 is low. The charged capacity is discharged through the optocoupler whenever L1 is low. With proper resistor and capacitor values a circuit can be obtained where the capacitor maintains current through the optocoupler and thereby maintains the grounding of P_{L1L2} for as long as L1 is only lower than L2 for short intervals, but is completely discharged when the signal progresses to times where L2 is generally higher compared to L1. In other words, the pulses occurring at relative high frequency, e.g. typically above 1 kHz, are converted so that the resulting phase signals as seen from the diodes in the optocouplers U1 and U2 resembles continuous phase signals only going through the baseline, typically being defined by zero potential, at a relative low frequency, e.g. typically between 20 to 200 Hz. The resulting signals are preferably resembling sine curves, but may comprise spurs, steps or other artefacts associated with the eliminated pulses, as long as the artefacts do not involve rapid rising from or returning to the baseline for a major part of pulses occurring in the phase signals L1, L2 and L3. Thereby a pulse generator PG according to the embodiment of fig. 5 is able to generate output pulse signals P_{L1L2} and P_{L2L3} with pulses indicative of the phase relation between L1 and L2, respectively L2 and L3, even for pulsed power signals, e.g. PWM phases.

Examples of suitable values for a preferred embodiment of the pulse generator of fig. 5 comprises:
D1, D2: Silicon diodes with Vf = 0.7 V, e.g. 1N40007
R1, R2: 300 kΩ
R5, R6: 1 kΩ
C1, C2: 3.3 nF
U1, U2: e.g. HCPL2731
R3, R4: 100 kΩ

The skilled person will appreciate that other value combinations will, also or instead, be suitable in some systems, and that the values may be optimized according to the switching frequency, AC frequency, voltages, etc. within the scope of the invention. Further, the skilled person will appreciate that common additional circuit parts for e.g. decoupling, noise suppression, EMC, stability, overload protection, smoothing, etc., or alternative, basically commonly functioning designs, e.g. flipping the pulses by pulling up P_{L1L2} when L1 is higher than L2 instead of the opposite, rearranging or splitting of components, etc., may be implemented.

As mentioned above, substitution of the optocouplers with other comparators suitable for comparing two phases and establish an output accordingly, e.g. other isolating components, e.g. digital isolators, or non-isolating components such as e.g. a transistor comparator, is possible.

Another aspect of the present invention regards the logic inside the pulse analyser PA which interprets the pulse signals P_{L1L2} and P_{L2L3} output from the pulse generator PG in order to verify that all three input phases are connected and in correct sequence. As mentioned above, it is a problem when using contemporary motor drivers which utilize frequency variations to control motors, compressors, etc., efficiently, that prior art phase sequence detectors either rely on a fixed phase frequency because they assume a fixed time difference, e.g. 20 ms, between two phases in order to verify the phase sequence, or that they need to use additional processing power to calculate the actual frequency of the phases to be able to set the correct phase difference to use in the phase sequence verification.

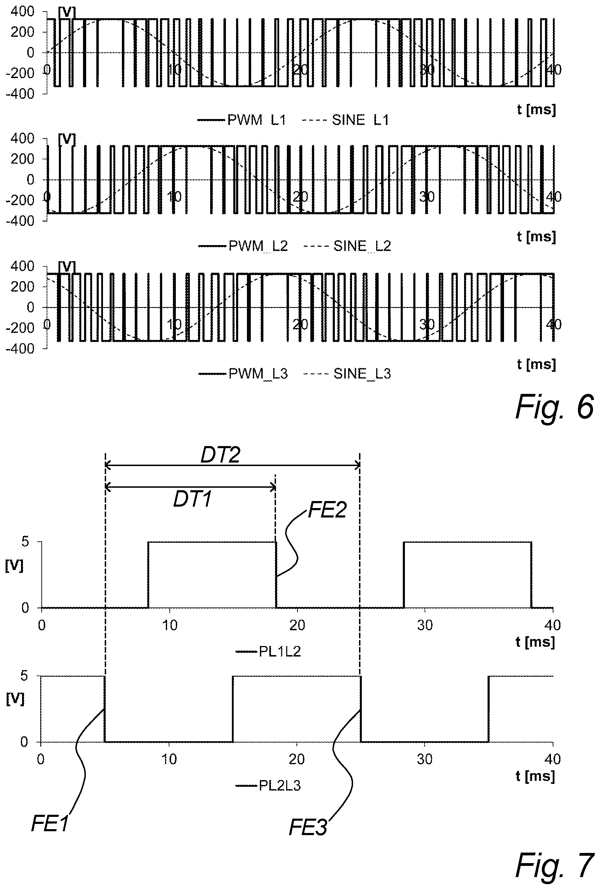

A preferred embodiment of the present invention uses a novel method for determining the phase sequence and test for other phase-related errors, e.g. phaseloss. This preferred method will now be described with reference to fig. 6 - 11.

Fig. 6 illustrates three input phases in correct sequence, i.e. in this example L1 - L2 - L3. The phases are pulse width modulated as this is a common and efficient way for a motor driver to establish control over the frequency, and thereby control the motor speed. The upper plot shows 40 ms of a pulse width modulated input phase PWM L1 with a PWM switching frequency of 1 kHz, which can be said to represent 2 periods of a 50 Hz sine wave phase SINE L1, illustrated by a dashed curve. The middle and bottom plots of fig. 6 correspond to the upper plot, but represent sine wave phases L2 and L3 that have been phase shifted 120 degrees and 240 degrees, respectively, at this frequency corresponding to phase shifts of approx. 6.67 ms and 13.33 ms, respectively. In other words, the three illustrated phases L1, L2 and L3 correspond to a common 3-phase AC power signal at 50 Hz. This frequency is selected for the current example as it corresponds with the above-described examples in fig. 3 and 4, but as mentioned above, the method of the present invention is particularly useful and advantageous when the power signal frequency is variable and thus unknown, seen from the phase sequence detector. The method described below can within the scope of the invention be used with variable driver frequencies, for example in a common approach varying between 20 Hz and 200 Hz. The switching frequency of 1 kHz used in the example is relatively low for many real embodiments within the scope of the present invention, but a low example value has been chosen for clarity of the illustrations. Any switching frequency, e.g. in the typical range of 1 kHz to 50 kHz, but also lower or even higher, is within the scope of the present invention.

By means of a pulse generator PG, e.g. the preferred embodiment described above with reference to fig. 5, the three PWM phases illustrated in fig. 6 result in pulse signals P_{L1L2} and P_{L2L3} as illustrated in fig. 7. The upper plot illustrates the pulse signal P_{L1L2} indicative of phase differences between phases L1 and L2, and the lower plot illustrates the pulse signal P_{L2L3} indicative of phase differences between phases L2 and L3. The plots are scaled to correspond with the time scale of fig. 6, and it can be seen by comparing fig. 6 and fig. 7 that P_{L1L2} comprises a rising edge at the point where the level of the L2 sine-representation gets above the level of the L1 sine-representation, or in other words, the point where the increasing duty cycle of L2 passes the decreasing duty cycle of L1. Similarly, P_{L1L2} comprises a falling edge FE2 at the point where the situation flips and the duty cycle of D2 decreases below the duty cycle of L1. The same can be seen in the lower plot of fig. 7 representing P_{L2L3}, by comparing with phases L2 and L3.

The two pulse signals are analysed according to a preferred embodiment of the invention by detecting falling edges, possible implemented as negative interrupts, of any of the two pulse signals and carrying out the following analysis:
1. A falling edge in P_{L2L3} starts the analysis, e.g. falling edge FE1 in the example of fig. 7.
2. The next two falling edges are detected, independent of which pulse signal they occur in, i.e. falling edges FE2 and FE3 in the example of fig. 7.
3. The percentage that the time DT1 between the first two falling edges, i.e. FE1 and FE2 in the example, represents of the time DT2 between the first and third falling edges, i.e. FE1 and FE3 in the example, is calculated. In other words, the ratio of DT1/DT2 in the example of fig. 7.
4. As seem from fig. 7, the ratio DT1/DT2 is 2/3, i.e. approx. 66.7%. This means, that the phase sequence is correct.

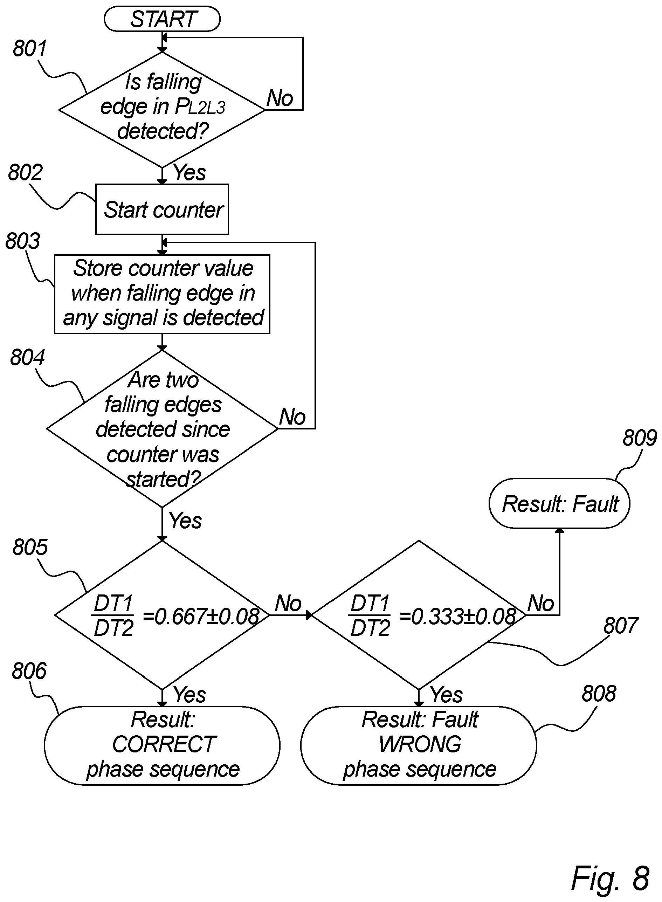

A basic embodiment of the advantageous method of determining phase sequence according to the present invention is illustrated in more detail by the flow chart in fig. 8.

A decision 801 is iterated until a falling edge is detected in P_{L2L3}. When that happens, a counter is started in step 802 in order to determine the time to further falling edges. In step 803 the counter value is registered if a falling edge has been detected in any of P_{L1L2} and P_{L2L3}, and this step is also iterated until it is determined by decision 804 that counter values have been stored for two falling edges.

When a total of three falling edges have been detected, i.e. the triggering edge in P_{L2L3}, e.g. FE1 in fig. 7, and the two additional falling edges for which counter values have been registered, e.g. FE2 and FE3 in fig. 7, the decision step 805 compares the ratio of the first and second registered counter values, represented by DT1 and DT2 in fig. 7, with two thirds, i.e. approx. 0.667 or 66.7%. Preferably the decision step 805 is implemented to allow a predetermined tolerance in order to avoid e.g. small variations or low counter resolutions to lead to false error detections. The tolerance may e.g. be set to +/- 0.08, i.e. +/- 8 percentage points.

If the result of decision step 805 is that the ratio is indeed within an acceptable range of two thirds, the end result 806 is established, i.e. that the sequence of the provided phases L1, L2 and L3 are correct.

If the result of step 805 is not true, the ratio of DT1/DT2 is instead in step 807 compared to one third, i.e. approx. 0.333 or 33.3%, preferably with an acceptable tolerance, e.g. +/- 0.08. If this statement is true, the end result 808 is establish, i.e. that the sequence of the provided phases is wrong, meaning that the phase cycle runs backwards: L3 - L2 - L1.

If the ratio DT1/DT2 is neither one third or two thirds, it can be determined that the connected phases have some kind of fault probably other than wrong phase sequence, leading to the end result 809.

It is noted that the algorithm can within the scope of the present invention be changed to start by detecting a falling edge in P_{L1L2} instead of P_{L2L3}, in which case the ratio of 33.3% denotes a correct sequence, or be changed to watch rising edges or other features or derived values that can be used to represent the pulse of the pulse signals or other indicatives of the phase differences between the 3 phases.

The counter mentioned above may within the scope of the invention be any suitable device or means for establishing a representation of sequential difference. It does not necessarily have to measure the absolute time, e.g. in milliseconds, but can instead as well simply count clock ticks or other relatively regularly occurring events, or, if the pulse signals have been sampled, just count the samples, as it is sufficient for the method of the present invention to simply determine a ratio between two time intervals. It is not necessary to derive the actual time differences, though such an embodiment would also be within the scope of the invention. Note, that by only relying on comparing ratios, the present invention succeeds in not having to know or measure the signal frequencies, nor being dependent on the signal frequencies being fixed. In other words, the present invention allows determining phase sequence errors in phases established by a variable frequency motor driver.

The method of the present invention for detecting phase sequence is preferably carried out very soon after the phases become live, at least when used in a motor protection application where the detection of an error typically should result in the motor being shut down, preferably even before the forces in the motor has become strong enough to damage motor components or attached machinery. In an embodiment the phase sequence detection is carried out after a small delay long enough to stabilize the motor driver frequencies, but short enough to have time to shut down the motor before it gets damaged if an error state is detected. An example of a suitable delay in some applications is e.g. 50 ms. On the contrary, in some embodiments it is important that the compressor does not get time to start, in order to not have the phase sequence detector being confused about any phantom phases generated by the compressor.

Further, the method of the present invention may in some embodiments be carried out only once or a few times at each start, as the most probable error states are related to the phases simply being physically connected in a wrong way, e.g. in the wrong order, or with bad or no connection. Hence, when it has first been determined that everything runs fine, it might in some embodiments of the invention be considered acceptable to shut down the phase sequence detector and release processing power, e.g. for other monitoring tasks. In other embodiments of the invention it may be considered relevant to maintain the phase sequence detection algorithm running at all times, for example to detect if the pulse generator is disconnected from the motor during use.

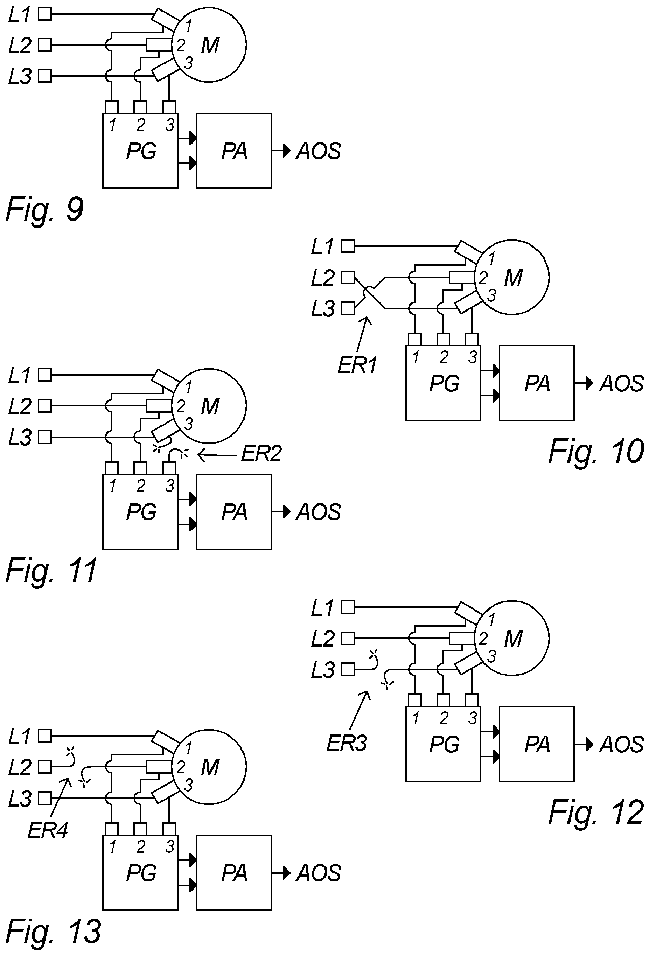

Figs. 9 - 13 illustrate a few of the possible ways to connect three phases L1, L2, L3, to three motor terminals M1, M2, M3, and three pulse generator terminals PG1, PG2, PG3. Fig. 9 shows a correct connection, corresponding to the embodiment of fig. 1, where both the motor and the pulse generator are connected to each other by all three terminals, and have all three terminals connected corresponding phases. The motor or compressor will run fine, the pulse generator PG will be able to generate the pulse trains shown in fig. 7 and described above, and the pulse analyser PA will, when going through the flow chart of fig. 8 as described above, determine the DT1/DT2-ratio to about 66.7%, leading to a positive result.

Fig. 10 shows an incorrect way to connect the phases, where two phases have been switched, ER1, so that motor terminal M2 has been connected to phase L3, and motor terminal M3 has been connected to phase L2. Any occurrence of two phases being switched in a three phase system will lead to the phase sequence as seen from the motor M being the opposite of the expected, i.e. in the current example, L3 - L2 - L1 as mentioned above with reference to step 807 of fig. 8. In fig. 10 the phase sequence detector also receives the switched phases in the same manner as the motor, which is highly preferable as the phase sequence detector should determine any faults from the compressor's point of view. In other words, in a preferred embodiment, the phase sequence detector, or at least the pulse generator part thereof, is arranged with correspondence to the motor or compressor in such a way, that it is highly unlikely that they can be connected to the phases differently.

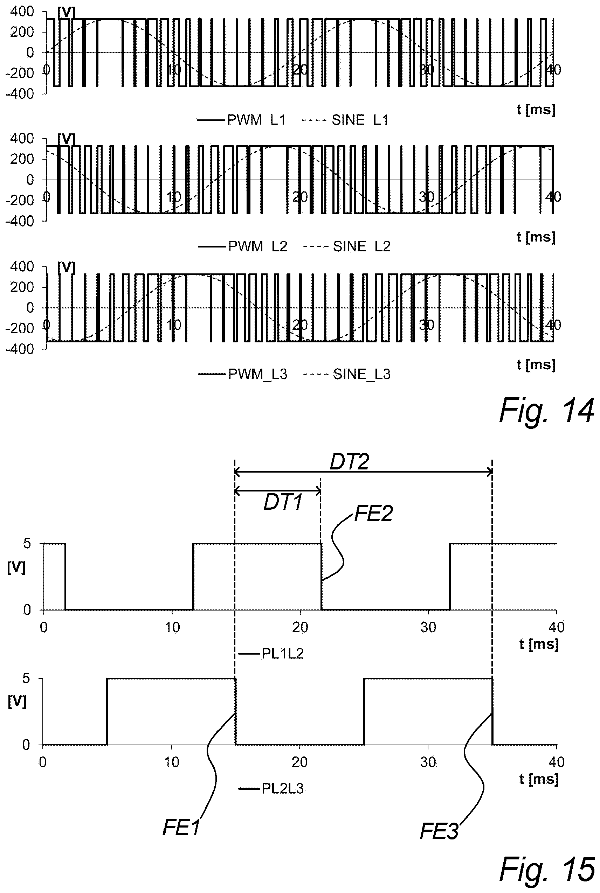

To illustrate the phases and pulse signals in the case of fig. 10 where the wrong phase sequence is applied, fig. 14 and 15 are provided. Fig. 14 corresponds to fig. 6 by all relevant details, except that in fig. 14 it is phase L3 that is shifted 120 degrees, and phase L2 that is shifted 240 degrees. In other words, fig. 14 illustrates three pulse width modulated phases which occur in the wrong sequence: L1 - L3 - L2.

Fig. 15 illustrates pulse signals P_{L1L2} and P_{L2L3} established by means of a pulse generator PG, e.g. the preferred embodiment described above with reference to fig. 5, from the three PWM phases illustrated in fig. 14. The details of the plots correspond to those of fig. 7 described above, except that they now represent a wrong phase sequence.

The two pulse signals are analysed according to a preferred embodiment of the invention by detecting falling edges, possibly implemented as negative interrupts, of any of the two pulse signals and carrying out the following analysis:
1. A falling edge in P_{L2L3} starts the analysis, e.g. falling edge FE1 in the example of fig. 15.
2. The next two falling edges are detected, independent of which pulse signal they occur in, i.e. falling edges FE2 and FE3 in the example of fig. 15.
3. The percentage that the time DT1 between the first two falling edges, i.e. FE1 and FE2 in the example, represents of the time DT2 between the first and third falling edges, i.e. FE1 and FE3 in the example, is calculated. In other words, the ratio of DT1/DT2 in the example of fig. 15.
4. As seem from fig. 15, the ratio DT1/DT2 is 1/3, i.e. approx. 33.3%. This means, that the phase sequence is opposite the expected, i.e. two phases have been switched.

It is noted that an alternative embodiment may start the analysis upon detection of a falling edge or other easily detectable event in the signal P_{L1L2}, in which case the ratio for an opposite sequence would be about 66.7% (and for a correct sequence, about 33.3%).

A different fault condition is illustrated in fig. 11 where the error ER2 indicates that one of the pulse generator terminals PG3 has been disconnected from the corresponding compressor terminal M3, or the wire is cut or the like.

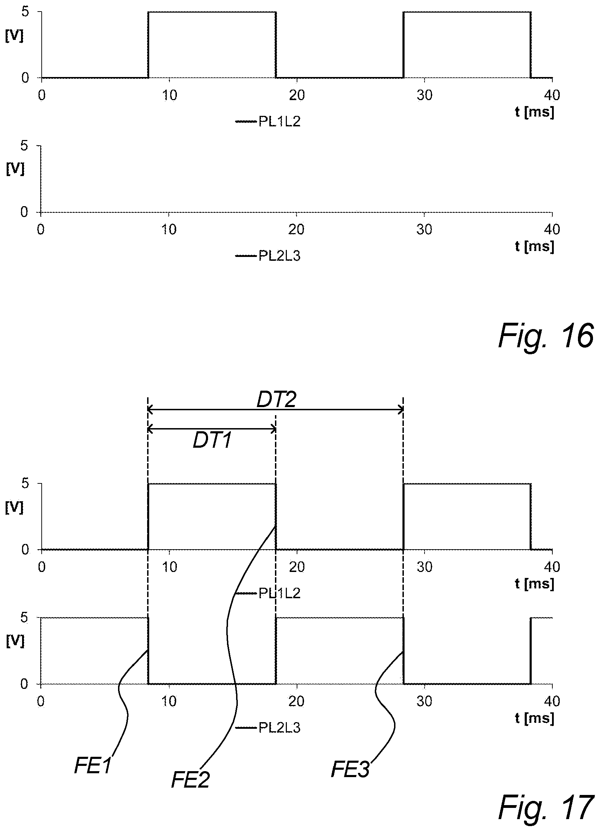

When the pulse generator terminal 3 is floating, it can be seen from the preferred embodiment of the pulse generator in fig. 5 and described above, that there will never go current through the second optocoupler U2, and in turn, no pulses will occur on the P_{L2L3} output, as illustrated in fig. 16. In the pulse analyser embodiment described above where measuring is triggered by a falling edge in the P_{L2L3} pulse train, the analysis will never get started with not pulses in this signal. Preferably a timeout functionality is implemented, which enables the phase sequence generator to determine that the pulse generator probably has lost phase L3 if the waiting times out. In an alternative embodiment where it is events on signal P_{L1L2} that triggers the analysis, the analysis will begin at the first falling edge of P_{L1L2} but as no edges are recognized in the other signal, the P_{L2L3}, the second and third edges detected will relate to the second and third pulse of the signal P_{L1L2}. This causes the ratio to be 50%, which the phase sequence detector in a preferred embodiment can recognize as an error state. The same happens if it is instead the first terminal PG1 that is floating in an embodiment with analysis triggering based on P_{L2L3}-pulses.

Even though the compressor M in the situation illustrated in Fig. 11 would probably run fine as it is correctly connected, the detection of an error condition is advantageous in order to signal to an operator that the phase sequence detector is not able to do its job until it has been correctly reconnected. In other words, the compressor is without safety measures for phase sequence errors until this connection is re-established.

Fig. 12 illustrated yet another erroneous condition ER3, specifically a missing phase on compressor terminal 3, and thereby also on pulse generator terminal 3. However, contrary to the situation in fig. 11, none of the pulse generator's terminals are floating, and it can therefore typically establish pulses on both outputs anyway, as current from the two remaining phases will for most motor configurations flow through the third part of the motor. A possible output is illustrated in fig. 17. As it is phase L3 that is missing in this example, signal P_{L1L2} will still work as usual by going low when phase L1 is higher than phase L2. However, for signal P_{L2L3} it is now when phase L2 is higher than phase L1 (instead of the missing L3) that this pulse train goes low. Consequently, as the two pulse trains have the same criteria just with opposite sign, they will have edges at the same times, but in opposite directions.

As evident from fig. 17, when analyzing these signals, the pulse analyzer will reach a DT1/DT2 ratio of 50%, thereby indicating a fault.

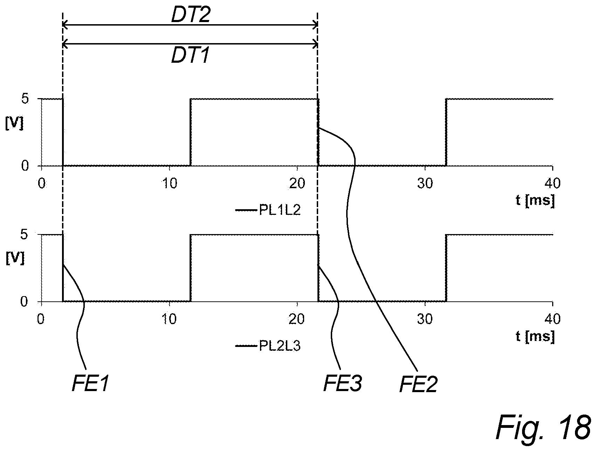

Yet an alternative connection fault ER4 is shown in fig. 13, where phase L2 is not connected to the compressor, and thereby preferably also not to the pulse generator. As the pulse generator, e.g. in the embodiment shown in fig. 5, thereby effectively makes the same judgment at both optocouplers, namely whether phase L1 is greater than phase L3, the two pulse trains becomes equal, as shown in fig. 18. Depending on how exactly the detection of falling edges is implemented, the pulse analyzer may count a first falling edge FE1 at one time, and two falling edge FE2, FE3 at a same, second time, thus making DT1 and DT2 equal, and the ratio 100%. Alternatively, the analyzer could be implemented to first count two edges at the same time, and then wait a period for the third, which would lead to DT1 being of practically zero length, and the DT1/DT2 ratio therefore being 0%. Both embodiments therefore would give a unique ratio that has not occurred in the other situations described above, and are therefore good for detecting the error. In an embodiment where the pulse analyzer may not be able to detect two concurrent pulses, it would work as if one of the pulse trains simply didn't exist, thereby leading to a ratio of 50% as described above. This would also clearly indicate error, although not to the same degree with specific information.

In a situation similar to the one in fig 11, but with pulse generator terminal 2 PG2 floating, the result would be similar to that described with reference to fig. 13, i.e. with the pulse trains getting equal.

In a preferred embodiment of the invention, the DT1/DT2 ratio is analyzed to derive more information than just whether or not there is a fault. In an embodiment using a pulse generator such as the one illustrated in fig. 5 and a pulse analyzer such as described with reference to fig. 8, i.e. where the ratio is based on falling edges, and is triggered by a falling edge on the P_{L2L3}-signal, the information may be derived according to table 1:

**Table 1**

| **DT1/DT2 ratio** | **Ratio tolerance** | **Possible fault reasons** |
|---|---|---|
| About 0.00 | e.g. 0.00 - 0.08 | • Compressor not connected to L2 |
| | | • Pulse generator not connected to L2 |
| About 0.33 | e.g. 0.25 - 0.41 | • Wrong phase sequence |
| About 0.50 | e.g. 0.42 - 0.58 | • Compressor not connected to L1 |
| | | • Compressor not connected to L3 |
| | | • Pulse generator not connected to L1 |
| About 0.67 | e.g. 0.59 - 0.75 | • Perfect - no fault |
| About 1.00 | e.g. 0.92 - 1.00 | • Compressor not connected to L2 |
| | | • Pulse generator not connected to L2 |
| No edge detected in P_{L2L3}-signal | Timeout e.g. 60 ms | • Pulse generator not connected to L3 |

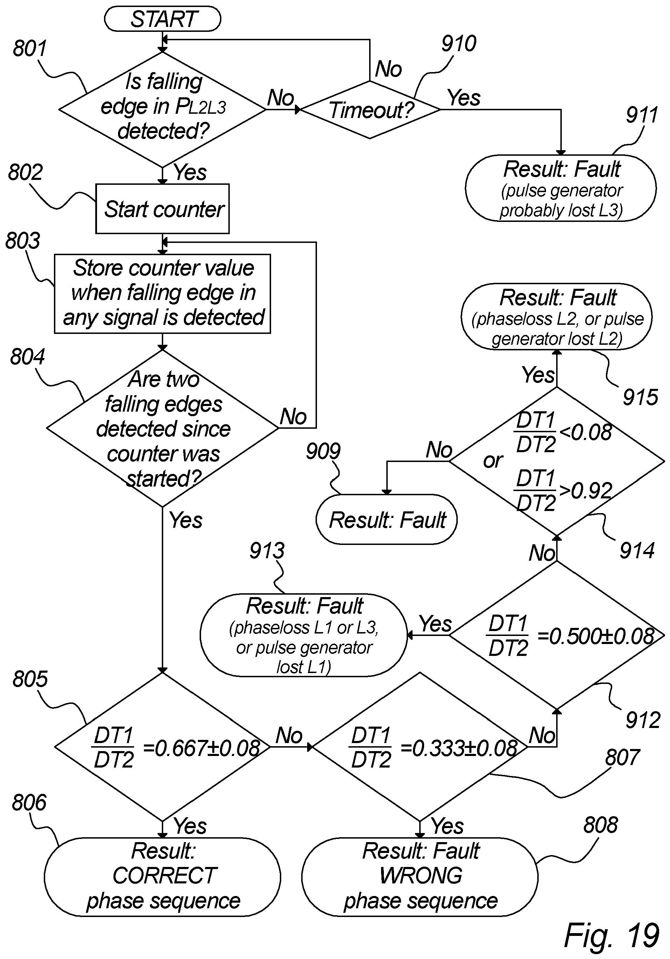

A preferred embodiment of the advantageous method of determining phase sequence and errors according to the present invention is illustrated in more detail by the flow chart in fig. 19. The main route and results in the flow chart of fig. 19 equals that of fig. 8 described above, but the flow chart in fig. 19 has been enhanced with more error detecting sub-algorithms to enable determining the kind of faults other than wrong phase sequence, for example according to table 1 above.

The algorithm preferably starts when the power for the compressor is turned on. This is easily detected by the occurrence of pulses in any of the two pulse signals P_{L1L2} and P_{L2L3}, but any other implementation, e.g. to power the phase sequence detector from the motor driver signal, is within the scope of the invention.

In decision 801 is determined if a falling edge has occurred in P_{L2L3} since the analysis started. The first additional step compared to fig. 8 is that a timer is watched in decision 910 to determine when to conclude that a missing falling edge in P_{L2L3} means that something is wrong. The timeout is in a preferred embodiment based on the lowest possible frequency with some additional time added, e.g. for a motor driver with lowest driving frequency of 20 Hz, the timeout could preferably be set to the period time of 20 Hz, i.e. 50 ms, and a tolerance of e.g. 10 ms, resulting in a timeout value of 60 ms. In another embodiment, e.g. when the lowest driver frequency is unknown, the timeout could simply be set to a relatively high value, e.g. 100 ms or 200 ms.

If a timeout occurs before any falling edge is detected in P_{L2L3}, it is concluded in step 911 that the pulse generator terminal that was meant to be connected to phase L3 is probably floating as described with reference to fig. 11 above,, and the phase sequence detector can output an error status accordingly.

As described above with respect to fig. 8, in step 803 the counter value is registered if a falling edge has been detected in any of P_{L1L2} and P_{L2L3}, and this step is also iterated until it is determined by decision step 804 that counter values have been stored for two falling edges.

In an alternative embodiment, the timeout decision step is also applied while detecting the 2^{nd} and 3^{rd} edge, thus requiring the edge detection steps to detect 3 falling edges, starting with one in P_{L2L3}, within the single timeout interval. More reasons than indicated by result 911 are then, however, possible if the timeout occurs. In this embodiment the same counter that is started in step 802 may preferably be used also for determining when a timeout has occurred. In that case, the timeout value should be determined in clock events, samples, milliseconds or another unit comparable with the unit of measure associated with the relevant counter.

In an alternative embodiment, the detection of any falling edge triggers the starting of the counter, etc., and the ratio to compare with in steps 805 and 807 are changed according to which pulse signal the first detected falling edge occurred in.

At the main route of the flow chart of fig. 19 an embodiment of the invention could have an addition step before decision step 805 to confirm that at least one falling edge have been detected in P_{L1L2}, and if not, assert that L1 has been lost. Thereby all the ratio comparisons could be disregarded and a fault indicating that the pulse generator has probably lost L1 be stated.

The ratio comparison steps 805 and 807, and the corresponding comparison success result steps 806 and 808, respectively, equals in this embodiment the corresponding steps in the embodiment described above with reference to fig. 8. However, if the pulse delay ratio DT1/DT2 neither corresponds to approx. one third or two thirds, the present embodiment may go on to further analysis of the determined ratio.

In decision step 912, if the pulse delay ratio is 50% within a tolerance, the result 913 is indicated, i.e. a fault condition most probably meaning that the compressor is not connected to either L1 or L3, or the pulse generator is not connected to L1. The reasoning is described in more detail above with reference to figs. 11, 12 and 17.

In decision step 914 is tested if the two pulse trains are more or less equal, i.e. with a pulse delay ratio of about 0% or about 100%. This would normally mean according to result step 915 that phase L2 is missing, either from the compressor, or just from the pulse generator, as described above with reference to fig. 13. It is noted, as also mentioned above, that if the pulse analyzer is implemented so that it is not able to detect two concurrent pulses, the two equal pulse trains in case of loss of L2 would be seen from the pulse analyzer as if one of the pulse trains simply didn't exist, thereby leading to a ratio of 50%. As this is a design question and the chosen implementation thereby known at runtime, it would simply mean that the list of possible faults if result step 913 is reached should be appended with loss of L2 if relevant for the implementation.

If the DT1/DT2 ratio determined has not resulted in affirmative in any of the decision steps, the pulse analysis may end up at a general error result 909.

It is noted, that the alternative embodiments and variations described with reference to the embodiment of fig. 8 above also apply to the embodiment of fig. 19 within the scope of the invention.

Alternative embodiments combining the basic method of fig. 8 with only one or some of the additional steps described with reference to, or shown in, fig. 19 or other alternatives mentioned above are within the scope of the present invention.

In an alternative embodiment of the invention, the phase sequence detecting method comprises an additional step, preferably carried out as one of the first steps in the method, whereby the received pulse signals are analysed for determining if one of the phases used to establish the pulse signals is a so-called phantom phase, i.e. a phase generated or maintained by the running motor after loss of the corresponding phase from the driver. If a phantom phase is detected, the phase sequence detection method should preferably regard the detected phantom phase as a lost phase, and signal an error condition accordingly. The phantom phase detection may be facilitated by a pulse generator PG comprising a phantom phase filter.

## Claims

1. A phase sequence detection method for determining phase sequence in a 3-phase motor driver signal, the phase sequence detection method comprising the steps of
receiving a first pulse train (P_{L1L2}), pulses of the first pulse train being indicative of a phase difference between a first phase (L1) and a second phase (L2); and
receiving a second pulse train (P_{L2L3}), pulses of the second pulse train being indicative of a phase difference between a second phase (L2) and a third phase (L3);
**characterised in that** said 3-phase motor driver signal is a variable frequency signal and the method further comprises the steps of
determining a pulse shift ratio representing a ratio of a first timing difference (DT1) to a second timing difference (DT2) of said first and second pulse trains; and
determining said phase sequence of said 3-phase motor driver signal on the basis of said pulse shift ratio, wherein
said steps of determining said pulse shift ratio and determining said phase sequence are obtained by the steps of:
determining said first timing difference (DT1) representing a relative time between a first pulse event (FE1) of one of said first or second pulse trains and a second pulse event (FE2) of one of said first or second pulse trains;
determining said second timing difference (DT2) representing a relative time between said first pulse event (FE1) and a third pulse event (FE3) of one of said first or second pulse trains;
determining said phase sequence of said 3-phase motor driver signal as being first - second - third phase when said first timing difference (DT1) amounts to one third of said second timing difference (DT2) subject to a predetermined tolerance when said first pulse event (FE1) occurred in said first pulse train (P_{L1L2}), or when said first timing difference (DT1) amounts to two thirds of said second timing difference (DT2) subject to a predetermined tolerance when said first pulse event (FE1) occurred in said second pulse train (P_{L2L3}).

2. The phase sequence detection method according to claim 1, wherein said method further comprises at least one of the following steps:
determining a phase loss of said first phase (L1) or said third phase (L3) when said first timing difference (DT1) amounts to one half of said second timing difference (DT2) subject to a predetermined tolerance;
determining a phase loss of said second phase (L2) when said first timing reference (DT1) amounts to zero or equals said second timing difference (DT2) subject to predetermined tolerances.

3. The phase sequence detection method according to claim 1 or 2, wherein the method comprises a step of having a pulse generator (PG) establish said first pulse train (P_{L1L2}) and said second pulse train (P_{L2L3}) on the basis of the first phase (L1), second phase (L2) and third phase (L3) of said 3-phase motor driver signal; and wherein the method further comprises at least one of the following steps:
determining that the pulse generator (PG) is not connected to said first phase (L1) when no pulse events are detected in said first pulse train (P_{L1L2}) within a predetermined timeout time, e.g. 60 ms, or among first, second and third pulse events (FE1, FE2, FE3) of said pulse trains (P_{L1L2}, P_{L2L3});
determining that the pulse generator (PG) is not connected to said third phase (L3) when no pulse events are detected in said second pulse train (P_{L2L3}) within a predetermined timeout time, e.g. 60 ms, or among said first, second and third pulse events (FE1, FE2, FE3).

4. The phase sequence detection method according to any of the claims 1 to 3, wherein said 3-phase motor driver signal is a variable frequency driver signal.

5. The phase sequence detection method according to any of the claims 1 to 4, wherein said 3-phase motor driver signal is a pulse width modulated PWM driver signal.

6. The phase sequence detection method according to any of the claims 3 to 5, wherein the pulse generator (PG) comprises first and second pulse conversion parts (C1, R5, C2, R6) arranged to convert pulsed signals, e.g. PWM signals, at said 3-phase motor driver signal to substantially continuous signals.

7. The phase sequence detection method according to any of the claims 1 to 6, wherein the method comprises a step of starting a counter upon detection of said first pulse event (FE1), and wherein said first timing difference (DT1) is determined as a value of the counter upon detection of said second pulse event (FE2) and said second timing difference (DT2) is determined as a value of the counter upon detection of said third pulse event (FE3).

8. A phase sequence detector for use with a compressor (M), comprising
first, second and third phase inputs (L1, L2, L3) adapted for receiving a 3-phase compressor driver signal;
a pulse generator (PG) connected to said first, second and third phase inputs; and
a pulse analyser (PA) connected to first and second pulse outputs (P_{L1L2}, P_{L2L3}) of said pulse generator;
wherein said pulse generator (PG) is arranged to establish a first pulse train at said first pulse output (P_{L1L2}), pulses of the first pulse train being indicative of a phase difference between said first phase input (L1) and said second phase input (L2); and a second pulse train at said second pulse output (P_{L2L3}), pulses of the second pulse train being indicative of a phase difference between said second phase input (L2) and said third phase input (L3);
**characterised in that**
said compressor (M) is a frequency controlled compressor and said 3-phase compressor driver signal is a variable frequency signal; and
wherein said signal analyser (PA) is arranged to establish a pulse shift ratio representing a ratio of a first timing difference (DT1) to a second timing difference (DT2) of said first and second pulse outputs, and to determine a phase sequence of signals received at said first, second and third phase input (L1, L2, L3) on the basis of said pulse shift ratio;
wherein said signal analyser (PA) is arranged to determine a first timing difference (DT1) representing a relative time between a first pulse event (FE1) of one of said first or second pulse trains and a second pulse event (FE2) of one of said first or second pulse trains, and wherein said signal analyser (PA) is arranged to determine a second timing difference (DT2) representing a relative time between said first pulse event (FE1) of one of said first or second pulse trains and a third pulse event (FE3) of one of said first or second pulse trains; and
wherein said signal analyser (PA) is further arranged to determine a phase sequence of said 3-phase motor driving signal as being first - second - third phase when said first timing difference (DT1) amounts to one third of said second timing difference (DT2) subject to a predetermined tolerance when said first pulse event (FE1) occurred in said first pulse train (P_{L1L2}), or when said first timing difference (DT1) amounts to two thirds of said second timing difference (DT2) subject to a predetermined tolerance when said first pulse event (FE1) occurred in said second pulse train (P_{L2L3}).

9. The phase sequence detector according to claim 8, wherein said signal analyser (PA) comprises a counter, and wherein said signal analyser is arranged to start said counter upon detection of a first pulse event (FE1), e.g. a falling edge, of one of said first or second pulse trains, and to determine said first timing difference (DT1) as a value of the counter upon detection of a second pulse event (FE2) of one of said first or second pulse trains, and to determine said second timing difference (DT2) as a value of the counter upon detection of a third pulse event (FE3) of one of said first or second pulse trains.

10. The phase sequence detector according to claim 8 or 9, wherein said pulse generator (PG) comprises first and second pulse conversion parts (C1, R5, C2, R6) arranged to convert pulsed signals, e.g. PWM signals, at said 3-phase compressor driver signal to substantially continuous signals.

## Patentansprüche

1. Phasenfolge-Detektionsverfahren zum Bestimmen einer Phasenfolge in einem dreiphasigen Motorantriebsignal, wobei das Phasenfolge-Detektionsverfahren die folgenden Schritte umfasst:
Empfangen einer ersten Impulsfolge (P_{L1L2}), wobei Impulse der ersten Impulsfolge eine Phasenverschiebung zwischen einer ersten Phase (L1) und einer zweiten Phase (L2) repräsentieren; und
Empfangen einer zweiten Impulsfolge (P_{L2L3}), wobei Impulse der zweiten Impulsfolge eine Phasenverschiebung zwischen einer zweiten Phase (L2) und einer dritten Phase (L3) repräsentieren;
**dadurch gekennzeichnet, dass**
das dreiphasige Motorantriebsignal ein Signal mit variabler Frequenz ist und das Verfahren außerdem die folgenden Schritte umfasst:
Bestimmen eines Impulsverschiebungsverhältnisses, das ein Verhältnis einer ersten Zeitdifferenz (DT1) zu einer zweiten Zeitdifferenz (DT2) der ersten und zweiten Impulsfolge repräsentiert; und
Bestimmen der Phasenfolge des dreiphasigen Motorantriebsignals basierend auf dem Impulsverschiebungsverhältnis, wobei
die Schritte zum Bestimmen des Impulsverschiebungsverhältnisses und zum Bestimmen der Phasenfolge durch die folgenden Schritte erreicht werden:
Bestimmen der ersten Zeitdifferenz (DT1), die eine relative Zeitspanne zwischen einem ersten Impulsereignis (FE1) einer von der ersten oder zweiten Impulsfolge und einem zweiten Impulsereignis (FE2) einer von der ersten oder zweiten Impulsfolge repräsentiert;
Bestimmen der zweiten Zeitdifferenz (DT2), die eine relative Zeitspanne zwischen dem ersten Impulsereignis (FE1) und einem dritten Impulsereignis (FE3) einer von der ersten oder zweiten Impulsfolge repräsentiert;
Bestimmen der Phasenfolge des dreiphasigen Motorantriebsignals als die Folge erste - zweite - dritte Phase, falls die erste Zeitdifferenz (DT1) ein Drittel der zweiten Zeitdifferenz (DT2) beträgt, in Abhängigkeit von einer vorgegebenen Toleranz, falls das erste Impulsereignis (FE1) in der ersten Impulsfolge (P_{L1L2}) aufgetreten ist, oder falls die erste Zeitdifferenz (DT1) zwei Drittel der zweiten Zeitdifferenz (DT2) beträgt, in Abhängigkeit von einer vorgegebenen Toleranz, falls das erste Impulsereignis (FE1) in der zweiten Impulsfolge (P_{L2L3}) aufgetreten ist.

2. Phasenfolge-Detektionsverfahren nach Anspruch 1, wobei das Verfahren außerdem wenigstens einen der folgenden Schritte umfasst:
Feststellen eines Phasenausfalls der ersten Phase (L1) oder der dritten Phase (L3), falls die erste Zeitdifferenz (DT1) die Hälfte der zweiten Zeitdifferenz (DT2) beträgt, in Abhängigkeit von einer vorgegebenen Toleranz;
Feststellen eines Phasenausfalls der zweiten Phase (L2), falls die erste Zeitdifferenz (DT1) Null beträgt oder gleich der zweiten Zeitdifferenz (DT2) ist, in Abhängigkeit von vorgegebenen Toleranzen.

3. Phasenfolge-Detektionsverfahren nach Anspruch 1 oder 2, wobei das Verfahren einen Schritt umfasst, in dem ein Impulsgenerator (PG) die erste Impulsfolge (P_{L1L2}) und die zweite Impulsfolge (P_{L2L3}) basierend auf der ersten Phase (L1), der zweiten Phase (L2) und der dritten Phase (L3) des dreiphasigen Motorantriebsignals erzeugt, und wobei das Verfahren außerdem wenigstens einen der folgenden Schritte umfasst:
Feststellen, dass der Impulsgenerator (PG) nicht an die erste Phase (L1) angeschlossen ist, falls in der ersten Impulsfolge (P_{L1L2}) keine Impulsereignisse detektiert werden innerhalb einer vorgegebenen Maximalzeitspanne, beispielsweise 60 ms, oder unter den ersten, zweiten und dritten Impulsereignissen (FE1, FE2, FE3) der Impulsfolgen (P_{L1L2}, P_{L2L3});
Feststellen, dass der Impulsgenerator (PG) nicht an die dritte Phase (L3) angeschlossen ist, falls in der zweiten Impulsfolge (P_{L2L3}) keine Impulsereignisse detektiert werden innerhalb einer vorgegebenen Maximalzeitspanne, beispielsweise 60 ms, oder unter den ersten, zweiten und dritten Impulsereignissen (FE1, FE2, FE3).

4. Phasenfolge-Detektionsverfahren nach einem der Ansprüche 1 bis 3, wobei das dreiphasige Motorantriebsignal ein Antriebsignal mit variabler Frequenz ist.

5. Phasenfolge-Detektionsverfahren nach einem der Ansprüche 1 bis 4, wobei das dreiphasige Motorantriebsignal ein pulsweitenmoduliertes PWM Antriebsignal ist.

6. Phasenfolge-Detektionsverfahren nach einem der Ansprüche 3 bis 5, wobei der Impulsgenerator (PG) einen ersten und einen zweiten Impulswandlerteil (C1, R5, C2, R6) umfasst, die dafür eingerichtet sind, gepulste Signale, beispielsweise PWM-Signale, in dem dreiphasigen Motorantriebsignal in im Wesentlichen kontinuierliche Signale zu wandeln.

7. Phasenfolge-Detektionsverfahren nach einem der Ansprüche 1 bis 6, wobei das Verfahren einen Schritt umfasst, in dem mit der Detektion des ersten Impulsereignisses (FE1) ein Zähler gestartet wird, und wobei die erste Zeitdifferenz (DT1) als ein Wert des Zählers bei der Detektion des zweiten Impulsereignisses (FE2) bestimmt wird und die zweite Zeitdifferenz (DT2) als ein Wert des Zählers bei der Detektion des dritten Impulsereignisses (FE3) bestimmt wird.

8. Phasenfolgedetektor für den Einsatz mit einem Kompressor (M), Folgendes umfassend:
einen ersten, zweiten und dritten Phaseneingang (L1, L2, L3), die dafür eingerichtet sind, ein dreiphasiges Kompressorantriebsignal zu empfangen;
einen Impulsgenerator (PG), der mit dem ersten, zweiten und dritten Phaseneingang verbunden ist; und
einen Impulsanalysator (PA), der mit einem ersten und einem zweiten Impulsausgang (P_{L1L2}, P_{L2L3}) des Impulsgenerators verbunden ist;
wobei der Impulsgenerator (PG) dafür eingerichtet ist, am ersten Impulsausgang (P_{L1L2}) eine erste Impulsfolge zu erzeugen, wobei Impulse der ersten Impulsfolge eine Phasenverschiebung zwischen dem ersten Phaseneingang (L1) und dem zweiten Phaseneingang (L2) repräsentieren; und am zweiten Impulsausgang (P_{L2L3}) eine zweite Impulsfolge zu erzeugen, wobei Impulse der zweiten Impulsfolge eine Phasenverschiebung zwischen dem zweiten Phaseneingang (L2) und dem dritten Phaseneingang (L3) repräsentieren;
**dadurch gekennzeichnet, dass**
der Kompressor (M) ein frequenzgesteuerter Kompressor und das dreiphasige Kompressorantriebsignal ein Signal mit variabler Frequenz ist; und
wobei der Signalanalysator (PA) dafür eingerichtet ist, ein Impulsverschiebungsverhältnis zu ermitteln, das ein Verhältnis einer ersten Zeitdifferenz (DT1) zu einer zweiten Zeitdifferenz (DT2) der ersten und zweiten Impulsausgabe repräsentiert, und basierend auf dem Impulsverschiebungsverhältnis eine Phasenfolge von Signalen zu bestimmen, die am ersten, zweiten und dritten Phaseneingang (L1, L2, L3) anliegen;
wobei der Signalanalysator (PA) dafür eingerichtet ist, eine erste Zeitdifferenz (DT1) zu bestimmen, die eine relative Zeitspanne zwischen einem ersten Impulsereignis (FE1) einer von der ersten oder zweiten Impulsfolge und einem zweiten Impulsereignis (FE2) einer von der ersten oder zweiten Impulsfolge repräsentiert, und wobei der Signalanalysator (PA) dafür eingerichtet ist, eine zweite Zeitdifferenz (DT2) zu bestimmen, die eine relative Zeitspanne zwischen dem ersten Impulsereignis (FE1) einer von der ersten oder zweiten Impulsfolge und einem dritten Impulsereignis (FE3) einer von der ersten oder zweiten Impulsfolge repräsentiert; und
wobei der Signalanalysator (PA) außerdem dafür eingerichtet ist, eine Phasenfolge des dreiphasigen Motorantriebsignals als die Folge erste - zweite - dritte Phase zu bestimmen, falls die erste Zeitdifferenz (DT1) ein Drittel der zweiten Zeitdifferenz (DT2) beträgt, in Abhängigkeit von einer vorgegebenen Toleranz, falls das erste Impulsereignis (FE1) in der ersten Impulsfolge (P_{L1L2}) aufgetreten ist, oder falls die erste Zeitdifferenz (DT1) zwei Drittel der zweiten Zeitdifferenz (DT2) beträgt, in Abhängigkeit von einer vorgegebenen Toleranz, falls das erste Impulsereignis (FE1) in der zweiten Impulsfolge (P_{L2L3}) aufgetreten ist.

9. Phasenfolgedetektor nach Anspruch 8, wobei der Signalanalysator (PA) einen Zähler umfasst und wobei der Signalanalysator dafür eingerichtet ist, mit der Detektion eines ersten Impulsereignisses (FE1) einer von der ersten oder zweiten Impulsfolge, beispielsweise einer fallenden Flanke, den Zähler zu starten, und die erste Zeitdifferenz (DT1) als einen Wert des Zählers bei der Detektion eines zweiten Impulsereignisses (FE2) einer von der ersten oder zweiten Impulsfolge zu bestimmen, und die zweite Zeitdifferenz (DT2) als einen Wert des Zählers bei der Detektion eines dritten Impulsereignisses (FE3) einer von der ersten oder zweiten Impulsfolge zu bestimmen.

10. Phasenfolgedetektor nach Anspruch 8 oder 9, wobei der Impulsgenerator (PG) einen ersten und einen zweiten Impulswandlerteil (C1, R5, C2, R6) umfasst, die dafür eingerichtet sind, gepulste Signale, beispielsweise PWM-Signale, in dem dreiphasigen Kompressorantriebsignal in im Wesentlichen kontinuierliche Signale zu wandeln.

## Revendications

1. Procédé de détection de séquence de phase pour déterminer une séquence de phase dans un signal de commande de moteur triphasé, le procédé de détection de séquence de phase comprenant les étapes ci-dessous consistant à :
recevoir un premier train d'impulsions (P_{L1L2}), les impulsions du premier train d'impulsions étant indicatives d'une différence de phase entre une première phase (L1) et une deuxième phase (L2) ; et
recevoir un second train d'impulsions (P_{L2L3}), les impulsions du second train d'impulsions étant indicatives d'une différence de phase entre une deuxième phase (L2) et une troisième phase (L3) ;
**caractérisé en ce que** :
ledit signal de commande de moteur triphasé est un signal de fréquence variable, et
**en ce que** le procédé comprend en outre les étapes ci-dessous consistant à :
déterminer un rapport de décalage d'impulsions représentant un rapport d'une première différence de temporisation (DT1) à une seconde différence de temporisation (DT2) desdits premier et second trains d'impulsions ; et
déterminer ladite séquence de phase dudit signal de commande de moteur triphasé sur la base dudit rapport de décalage d'impulsions, dans lequel lesdites étapes de détermination dudit rapport de décalage d'impulsions et de détermination de ladite séquence de phase sont obtenues par les étapes ci-dessous consistant à :
déterminer ladite première différence de temporisation (DT1) représentant un temps relatif entre un premier événement impulsionnel (FE1) de l'un desdits premier et second trains d'impulsions et un deuxième événement impulsionnel (FE2) de l'un desdits premier et second trains d'impulsions ;
déterminer ladite seconde différence de temporisation (DT2) représentant un temps relatif entre ledit premier événement impulsionnel (FE1) et un troisième événement impulsionnel (FE3) de l'un desdits premier et second trains d'impulsions ;
déterminer ladite séquence de phase dudit signal de commande de moteur triphasé comme correspondant à la première phase, la deuxième phase, ou la troisième phase, lorsque ladite première différence de temporisation (DT1) s'élève à un tiers de ladite seconde différence de temporisation (DT2) sous réserve d'une tolérance prédéterminée lorsque ledit premier événement impulsionnel (FE1) s'est produit dans ledit premier train d'impulsions (P_{L1L2}), ou lorsque ladite première différence de temporisation (DT1) s'élève à deux tiers de ladite seconde différence de temporisation (DT2) sous réserve d'une tolérance prédéterminée lorsque ledit premier événement impulsionnel (FE1) s'est produit dans ledit second train d'impulsions (P_{L2L3}).

2. Procédé de détection de séquence de phase selon la revendication 1, dans lequel ledit procédé comprend en outre au moins l'une des étapes ci-dessous consistant à :
déterminer une perte de phase de ladite première phase (L1) ou de ladite troisième phase (L3) lorsque ladite première différence de temporisation (DT1) s'élève à la moitié de ladite seconde différence de temporisation (DT2) sous réserve d'une tolérance prédéterminée ;
déterminer une perte de phase de ladite deuxième phase (L2) lorsque ladite première différence de temporisation (DT1) est égale à zéro ou est égale à ladite seconde différence de temporisation (DT2) sous réserve de tolérances prédéterminées.

3. Procédé de détection de séquence de phase selon la revendication 1 ou 2, dans lequel le procédé comprend une étape consistant à amener un générateur d'impulsions (PG) à établir ledit premier train d'impulsions (P_{L1L2}) et ledit second train d'impulsions (P_{L2L3}) sur la base de la première phase (L1), la deuxième phase (L2) et la troisième phase (L3) dudit signal de commande de moteur triphasé ; et dans lequel le procédé comprend en outre au moins l'une des étapes ci-dessous consistant à :
déterminer que le générateur d'impulsions (PG) n'est pas connecté à ladite première phase (L1) lorsqu'aucun événement impulsionnel n'est détecté dans ledit premier train d'impulsions (P_{L1L2}) pendant un temps de fin de temporisation prédéterminé, par exemple de 60 ms, ou parmi les premier, deuxième et troisième événements impulsionnels (FE1, FE2, FE3) desdits trains d'impulsions (P_{L1L2}, P_{L2L3}) ;
déterminer que le générateur d'impulsions (PG) n'est pas connecté à ladite troisième phase (L3) lorsqu'aucun événement impulsionnel n'est détecté dans ledit second train d'impulsions (P_{L2L3}) pendant un temps de fin de temporisation prédéterminé, par exemple de 60 ms, ou parmi lesdits premier, deuxième et troisième événements impulsionnels (FE1, FE2, FE3).

4. Procédé de détection de séquence de phase selon l'une quelconque des revendications 1 à 3, dans lequel ledit signal de commande de moteur triphasé est un signal de commande de fréquence variable.

5. Procédé de détection de séquence de phase selon l'une quelconque des revendications 1 à 4, dans lequel ledit signal de commande de moteur triphasé est un signal de commande à modulation d'impulsions en durée, PWM.

6. Procédé de détection de séquence de phase selon l'une quelconque des revendications 3 à 5, dans lequel le générateur d'impulsions (PG) comprend des première et seconde parties de conversion d'impulsions (C1, R5, C2, R6) agencées de manière à convertir des signaux pulsés, par exemple des signaux PWM, au niveau dudit signal de commande de moteur triphasé, en des signaux sensiblement continus.

7. Procédé de détection de séquence de phase selon l'une quelconque des revendications 1 à 6, dans lequel le procédé comprend une étape consistant à démarrer un compteur lors de la détection dudit premier événement impulsionnel (FE1), et dans lequel ladite première différence de temporisation (DT1) est déterminée comme étant une valeur du compteur lors de la détection dudit deuxième événement impulsionnel (FE2) et ladite seconde différence de temporisation (DT2) est déterminée comme étant une valeur du compteur lors de la détection dudit troisième événement impulsionnel (FE3).

8. Détecteur de séquence de phase destiné à être utilisé avec un compresseur (M), comprenant des première, deuxième et troisième entrées de phase (L1, L2, L3) en mesure de recevoir un signal de commande de compresseur triphasé ;
un générateur d'impulsions (PG) connecté auxdites première, deuxième et troisième entrées de phase ; et
un analyseur de signaux (PA) connecté à des première et seconde sorties d'impulsions (P_{L1L2}, P_{L2L3}) dudit générateur d'impulsions ;
dans lequel ledit générateur d'impulsions (PG) est agencé de manière à établir un premier train d'impulsions au niveau de ladite première sortie d'impulsions (P_{L1L2}), les impulsions du premier train d'impulsions étant indicatives d'une différence de phase entre ladite première entrée de phase (L1) et ladite deuxième entrée de phase (L2) ; et un second train d'impulsions au niveau de ladite seconde sortie d'impulsions (P_{L2L3}), les impulsions du second train d'impulsions étant indicatives d'une différence de phase entre ladite deuxième entrée de phase (L2) et ladite troisième entrée de phase (L3) ;
**caractérisé en ce que** :
ledit compresseur (M) est un compresseur commandé en fréquence et ledit signal de commande de compresseur triphasé est un signal de fréquence variable ; et
dans lequel ledit analyseur de signaux (PA) est agencé de manière à établir un rapport de décalage d'impulsions représentant un rapport d'une première différence de temporisation (DT1) à une seconde différence de temporisation (DT2) desdites première et seconde sorties d'impulsions, et à déterminer une séquence de phase de signaux reçus au niveau desdites première, deuxième et troisième entrées de phase (L1, L2, L3) sur la base dudit rapport de décalage d'impulsions ;
dans lequel ledit analyseur de signaux (PA) est agencé de manière à déterminer une première différence de temporisation (DT1) représentant un temps relatif entre un premier événement impulsionnel (FE1) de l'un desdits premier et second trains d'impulsions et un deuxième événement impulsionnel (FE2) de l'un desdits premier et second trains d'impulsions, et dans lequel ledit analyseur de signaux (PA) est agencé de manière à déterminer une seconde différence de temporisation (DT2) représentant un temps relatif entre ledit premier événement impulsionnel (FE1) de l'un desdits premier et second trains d'impulsions et un troisième événement impulsionnel (FE3) de l'un desdits premier et second trains d'impulsions ; et
dans lequel ledit analyseur de signaux (PA) est en outre agencé de manière à déterminer une séquence de phase dudit signal de commande de moteur triphasé comme correspondant à la première phase, la deuxième phase, ou la troisième phase, lorsque ladite première différence de temporisation (DT1) s'élève à un tiers de ladite seconde différence de temporisation (DT2) sous réserve d'une tolérance prédéterminée lorsque ledit premier événement impulsionnel (FE1) s'est produit dans ledit premier train d'impulsions (P_{L1L2}), ou lorsque ladite première différence de temporisation (DT1) s'élève à deux tiers de ladite seconde différence de temporisation (DT2) sous réserve d'une tolérance prédéterminée lorsque ledit premier événement impulsionnel (FE1) s'est produit dans ledit second train d'impulsions (P_{L2L3}).

9. Détecteur de séquence de phase selon la revendication 8, dans lequel ledit analyseur de signaux (PA) comprend un compteur, et dans lequel ledit analyseur de signaux est agencé de manière à démarrer ledit compteur lors de la détection d'un premier événement impulsionnel (FE1), par exemple un front descendant, de l'un desdits premier et second trains d'impulsions, et à déterminer ladite première différence de temporisation (DT1) comme étant une valeur du compteur lors de la détection d'un deuxième événement impulsionnel (FE2) de l'un desdits premier et second trains d'impulsions, et à déterminer ladite seconde différence de temporisation (DT2) comme étant une valeur du compteur lors de la détection d'un troisième événement impulsionnel (FE3) de l'un desdits premier et second trains d'impulsions.

10. Détecteur de séquence de phase selon la revendication 8 ou 9, dans lequel ledit générateur d'impulsions (PG) comprend des première et seconde parties de conversion d'impulsions (C1, R5, C2, R6) agencées de manière à convertir des signaux puisés, par exemple des signaux PWM, au niveau dudit signal de commande de compresseur triphasé, en des signaux sensiblement continus.
